# EUROPEAN PATENT SPECIFICATION

(11) **EP 3 139 708 B1**
(45) Date of publication and mention of the grant of the patent: **21.06.2023**
(21) Application number: 16185910.3
(22) Date of filing: 26.08.2016
(51) Int. Cl.: H05B 39/08, H02P 27/02, H03K 17/725, H05B 1/02, H05B 47/10

(54) **TRIAC CONTROL SYSTEMS**
TRIAC-STEUERUNGSSYSTEME
SYSTÈMES DE COMMANDE D'UN TRIAC

(30) Priority: 02.09.2015 GB 201515569; 07.12.2015 GB 201521526
(43) Date of publication of application: 08.03.2017
(73) Proprietor: B.D.G. el S.r.l., 21020 Bardello (IT)
(72) Inventor: RYAN, Paul Thomas, Huntingdon, Cambridgeshire PE28 4AQ (GB)
(74) Representative: Marks & Clerk LLP

(56) References cited:
- EP-A1- 1 798 857
- EP-A2- 1 052 776
- GB-A- 2 330 704
- US-A- 4 878 010
- US-B1- 6 388 345

## Description

### Field of the invention

The present invention relates to triac power control systems.

### Background of the invention

Triacs (formally called bidirectional triode thyristors or bilateral triode thyristors) are used extensively in AC power control systems, and are often controlled by digital circuits, including microcontrollers. Because of their latching characteristic, triacs can be turned on by application of a short current pulse to their gate; when operated from digital circuits, the pulse is usually negative because this polarity is compatible with triac conduction in both polarities of the AC supply.

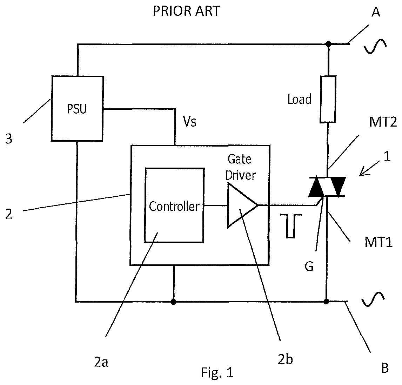

Fig. 1 shows a prior art AC power control system, which controls the voltage delivered to a load. The load is arranged in series with a triac 1 having power terminals labelled MT1 and MT2, and an AC voltage is applied to the combination of the load and triac 1 between terminals A and B. The triac is controlled by a control signal generated by a control unit 2 having a controller 2a (typically a microcontrol unit, MCU) for generating a pulse, and a driver circuit 2b used to amplify the current pulse and apply it to a gate (G) of the triac 1.

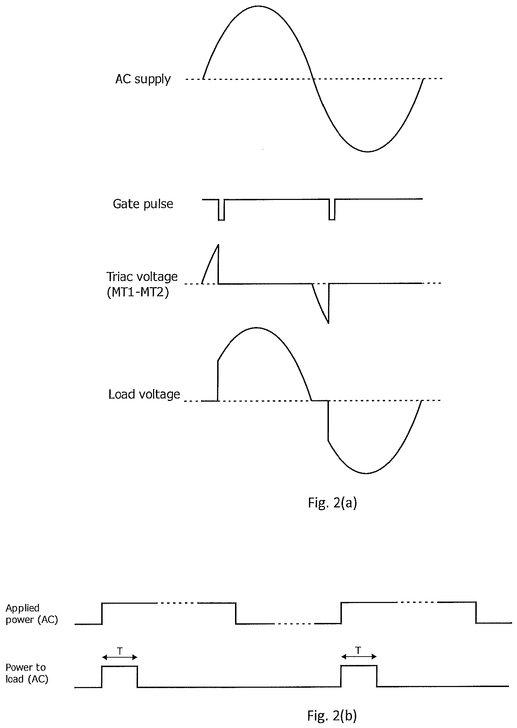

Fig. 2(a) shows, in the top line, the waveform of the AC voltage between terminals A and B. The second line is the signal generated by the control unit 2. The third line is the voltage across the triac 2, and the fourth (lowest) line is the voltage across the load.

The controller 2a and drive circuit 2b are powered by a separate low voltage power source unit 3 which is in turn powered by the AC power signal, so the 0V connection of the MCU 2 can be conveniently connected to one of the power terminals of the triac 1. An arrangement like this is shown in Fig. 1 of the AN442 Application note "Triac & Microcontrollers: the easy connection", published by STMicroelectronics (2004). A version with negative polarity is shown in Fig. 2.

By using low power circuits in the controller 2a and minimising the duration of the current pulse, the power requirements can be made low - reducing cost and consumption of the power supply circuit. Furthermore, this arrangement is advantageous for some applications where the controller 2a must also connect to other circuits that share a signal reference with the power terminal (MT1) of the triac.

However, the power supply unit 3 increases the cost of the power control system and reduces its reliability. Since the power supply 3 is connected directly to the mains supply voltage, it is exposed to high voltages - both nominal and surge (often related to lightning strikes on the electricity supply network). Its components can be highly stressed during surges, and this is a major cause of failure of such products in use. Though the power requirements of the controller are low, the power supply circuits need to be robust against such voltages and this adds to the cost, complexity and size of the power supply 3.

Some applications of triac control require accurate and/or sophisticated control and this is often best provided by using digital circuits for the controller, for example as a microcontroller. However, other applications may be more simple and tolerant of less accurate control, for example motor starting. Fig. 2(b) shows an application which provides a fixed on-time delay T. The upper line of Fig. 2(b) shows an AC power signal applied between points A and B, while the lower line of Fig. 2(b) shows the power which the control circuit applies across a load. The power applied to the load is zero except during a period of length T which immediately follows the rise in the power applied between the points A and B; during each period of length T, the power applied to the load is constant.

US 6388345 a light corner switch assembly in which an triac is controlled using a diac attached to a control gate of the triac. A controller is provided for controlling a transistor which is operative to disable the diac, and thereby prevent the triac being triggered by the diac. US 4878010 discloses an AC power switch control. Several control circuits are suggested, including a control circuit which includes a triac connected to two recifiers and controlled using a diac. GB2330704A discloses a switch unit including a triac for supplying AC supply circuit to a lamp. EP 1798857 shows an AC dimmer circuit including a triac under the control of a switch. EP 1052776A2 discloses a solid state electrical switch with a capacitor and resistor in parallel between a gate of a triac and an MT1 power terminal of the triac.

### Summary of the Invention

The present invention aims to provide a new and useful triac power control system, as defined by claim 1.

In general terms the invention proposes that a triac is controlled by a controller (typically an MCU) coupled to the gate terminal of the triac via at least a rectifier unit comprising at least one rectifier. The rectifier unit transmits a control signal from the controller to the triac, and additionally generates a power signal for powering the controller. A capacitive network is provided in parallel with the triac, and provides another input for the rectifier unit.

The capacitive network allows very low power consumption when the triac is held in the off-state (i.e. not triggered, with no power going to the load). This is significant for certain applications (e.g. control of a refrigerator) because the off-state power has to be very low. Other applications (e.g. controlling lights or a thermostat) would also benefit from similar low off-state power consumption.

Typically, the rectifier unit comprises a single rectifier unit which performs both these functions, although embodiments are possible in which the rectifier unit comprises two rectifier units which perform the two functions respectively.

Preferred embodiments of the invention are economical because the rectifier unit provides a common path for powering the controller and triggering the triac. In contrast to the conventional triac control systems described above, the circuitry which powers the controller in an embodiment of the present invention may take a simpler and cheaper form.

Further, it is possible to provide an embodiment of the invention with additional important protection functions with minimal additional cost and complexity. Specifically, embodiments of the power control system may be arranged to allow a protective mode of operation in which the triac is triggered to divert potentially damaging surges away from sensitive components. These components can therefore be less robust (smaller and lower cost) compared to an implementation that has no such protective mechanism. This mechanism, because it involves triggering the triac, is used in applications where occasional triggering is acceptable e.g. motor control in refrigerators, heaters, some lighting uses etc.

In many embodiments of the invention, the MCU is not directly electrically connected to one of the power terminals of the triac, and thus lacks a common signal reference, and this may make it less convenient if the MCU must communicate with other systems. However, there are many applications in which this is not a disadvantage. For example, in the application to starting of motor starting, the lack of a common signal reference is not a restriction because the operation can be based simply on timing or counting mains cycles. Other applications, in particular thermostats, can also use an embodiment of the invention provided that the other circuits have no current path to the AC power supply connections.

In some applications, it is be possible to provide the control function at lower cost than by using a MCU, specifically by using other arrangements such as discrete components (transistors, diodes etc.) or simple, low cost integrated circuits. Such embodiments may implement functions using analogue rather than digital techniques. Parameters such as switching time may then have larger tolerance due to the variable characteristics of components involved, but the tolerance may be acceptable in some applications, for example motor starting.

The disclosure describes a power supply circuit for controlling the supply of power from an alternating current power source to a load, the power supply circuit comprising:
a triac unit for arrangement in series with the load, the triac unit having a control input;
a controller for generating a control signal, the controller being operative to trigger the triac unit using the control signal; and
a rectifier unit comprising at least one rectifier;
the rectifier unit being operatively connected between the controller and the control input of the triac unit, and operative:
   (i) to control the triac unit in accordance with the control signal, and
   (ii) to transmit electrical power to the controller;
and characterized by further comprising:
   a capacitive network (ZL, ZH) connected in parallel with the triac unit (T1), a terminal of the capacitive network being electrically connected to an input (11) of the rectifier unit.

The disclosure also describes a method for controlling a power supply circuit which supplies power from an alternating current power source to a load, the power supply circuit comprising:
a triac unit in series with the load, the triac unit having a control input; and
a controller for generating a control signal, the controller being operative to trigger the triac unit using the control signal; and
the method comprising:
   using a rectifier unit comprising at least one rectifier:
      (i) to transmit the control signal to the control input of the triac unit, and
      (ii) to transmit electrical power to the controller;
   the method being characterized by the power supply circuit further comprising a capacitive network (ZL, ZH) in parallel with the triac unit (T1), a terminal of the capacitive network being electrically connected to an input (11) of the rectifier.

The capacitive network includes a first capacitive circuit (having two terminals connected respectively (i) to the input of the rectifier unit, and (ii) to a first terminal of the triac unit and to the load.

The capacitive network further contains another circuit connecting the input of the rectifier unit to a second terminal of the triac unit. This circuit may be a second capacitive component, but alternatively may be purely resistive.

The first capacitive circuit may include at least one resistive element in series with at least one capacitive component. This avoids excessive current flowing through the capacitive network under transient conditions.

Similarly, if the second capacitive circuit is present, it may include at least one resistive component in series with at least one capacitive component. This allows surge-protection behaviour.

The terms "circuit" and "network" are used here to mean one or more electrical components. The term "capacitive" network and "capacitive circuit" are used to mean networks or circuits including at least one capacitive component (a capacitor). The capacitive component may be in series with a resistive component, though preferably not in parallel with one.

Preferably, the power supply circuit further includes a power supply unit (10) for accumulating the electrical power transmitted by the rectifier unit, and supplying the electrical power to the controller (11).

Preferably, a single rectifier (B1) of the rectifier unit both controls the triac unit (T1) in accordance with the control signal, and transmits electrical power to the power supply unit.

Preferably, the rectifier (B1) has two inputs (I1, I2) and two outputs (O1, O2), the operative connections of the controller are to the outputs (01, 02) of the rectifier (B1), and the control input (G) of the triac unit (T1) is operatively connected to one of the inputs of the rectifier (B1).

Preferably, the rectifier (B1) is a full-wave rectifier.

### Brief description of the figures

Embodiments of the invention will now be described for the sake of example only with reference to the following drawings, in which
Fig. 1 shows a prior art triac power control system;
Fig. 2 is composed of Fig. 2(a) shows voltage waveforms in the power control system of Fig. 1, and Fig. 2(b) which shows an application for the controller of Fig. 1;
Fig. 3 shows a first embodiment of the invention;
Fig. 4 shows a second embodiment of the invention;
Fig. 5 shows part of a third embodiment of the invention, which is a variant of the embodiment of Fig. 3 or Fig. 4;
Fig. 6 shows part of a fourth embodiment of the invention, which is a variant fo the embodiment of Fig. 3 or Fig. 4; and
Fig. 7 shows a fifth embodiment of the invention.

### Detailed description of the embodiments

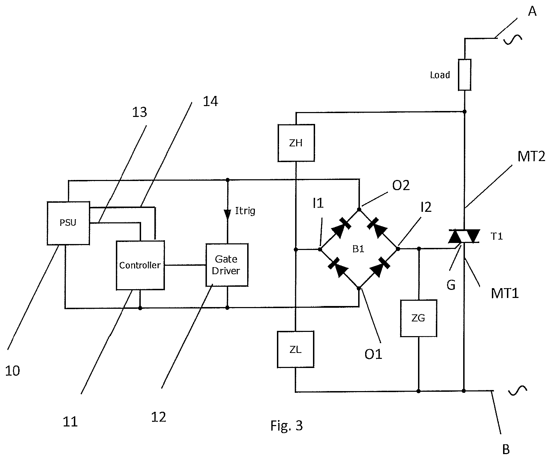

Referring firstly to Fig. 3, an embodiment of the invention is shown which is a power supply circuit for controlling how AC power (such as mains power) connected to points A and B delivered to a load. The power supply circuit includes a triac T1 having a control input (gate) G and power terminals MT1 and MT2. On/off control of the triac T1 is done by a controller 11 (typically a microcontroller), for generating a control signal for controlling the triac T1. The control signal is typically a (negative) current pulse.

The controller 11 is coupled to the gate G of the triac T1 via a rectifier B1 and, optionally, other circuits. In this embodiment, the control signal generated by the controller 11 is used to control a gate driver circuit 14 connected across the two outputs O1, O2 of the bridge B1. The gate driver circuit 14 amplifies the voltage pulse and a current Itrig passes through it. Typically, the gate driver simply produces a digital form of the output from the controller 11.

The controller 11 is powered by a power supply 10 via a power line 14. The power supply 10 draws its power from the output of the rectifier B1. The power supply unit 10 receives power once per half cycle, and only when the triac T1 is not conducting. It is typically designed to keep the controller operating from half-cycle to half-cycle, so that longer duration control is possible. Note that the power supply 10 is not exposed to mains voltage, so it can be designed in a very simple, compact and low cost way, i.e. it can be significantly simpler than the power supply unit of Fig. 1. At a minimum it is simply a capacitor for storing charge to keep the controller running to perform its function of generating the control signal. Optionally, the power supply 10 also has a voltage regulation function.

Optionally, the power supply 10 also has a function of controlling the timing with which the controller 11 generates the control signal. By this means the controller 11 may be controlled based on the timing of the mains supply. For example, an optional signal line 13 may be provided from the power supply 10 to the controller 11, and a detection circuit may be provided associated with the power supply 10 and operative to detect the rise of current or voltage from the rectifier into the power supply 10, and accordingly transmit a timing signal on the signal line 13 to the controller 11. The rise in the current or voltage from the rectifier into the power supply 10 indicates a rise of the magnitude (irrespective of the sign) of the voltage across the triac. The voltage across the triac rises as a result of the triac being in the off condition (since it was turned off in the previous mains half-cycle) and the magnitude of the mains voltage rising. Thus, the signal transmitted along the signal line 13 would be characteristic of the start of a mains half-cycle. In this way, the controller would be enabled to generate the control signal with a timing based on the timing of the AC signal (e.g. synchronised with certain points on the AC waveform), or the controller may count mains cycles and have a timing based on that.

It is envisaged that typically the controller 11 will be provided as a single integrated circuit (IC), which may include other functions such as regulation. The construction of the controller 11 and the gate driver circuit 12 will be well-known to a person skilled in the art. It may for example involve the use of components as described in document AN467 "NXP's 51 LPC-Microcontrollers and Triacs easily constructed", published by NXP BV (2013).

The power supply circuit further comprises impedances ZH, ZL and ZG. ZH and ZL have a capacitive component, and constitute a capacitive network in parallel with the triac. A first input I1 of the rectifier B1 is electrically connected to ZH and ZL, while the second input I2 of the rectifier B1 is connected to the gate G of the triac T1.

In Fig. 1 B1 is shown as a bridge rectifier, which is preferable, however other rectifier configurations are possible. In applications in which it is desired that the triac T1 is triggered in every half-cycle, the rectifier is a full-wave rectifier. However, it is conceivable that there could be applications in which the triac is only triggered once in each AC period (i.e. every other half-cycle), and in this case the rectifier could be a half wave rectifier; the power supply 10 would in this case only be powered in every other half-cycle, and would be typically designed to store enough power the controller 10 for the full AC period.

When the controller 11 generates a control signal, it is amplified by the gate driver circuit 14, the amplified control signal is transmitted by the rectifier B1 to the gate (G) of the triac T1. Current for the pulses is provided from the capacitive network ZL and ZH, from AC power conducted via the load. ZL and ZH may have complex characteristics provided they are capacitive, preferably mainly capacitive. However, it is possible to form an embodiment in which ZL is resistive with only ZH being capacitive. When the triac T1 is turned off and the AC voltage increases then the voltage across MT2 - MT1 also increases. This increases the voltage across ZL, and stores energy in its capacitive characteristic. The voltage across ZL also passes via the rectifier B1 to the power supply 10 for the controller 11 to power it. The power supply 10 may include capacitive energy storage to maintain supply voltage to the controller when there is no (or low) voltage across ZL. In applications where the controller needs to maintain function over a period longer than half of the AC cycle, the controller power supply would need to store sufficient energy to maintain operation from one non-conduction period of the triac to the next non-conduction period, when the energy can be recharged.

Preferably ZH does not include a significant current path which bypasses the capacitive elements of ZH. Thus, ZH is substantially capacitive. Using a substantially capacitive impedance for ZH allows very low power consumption when the triac is held in the off-state (i.e. not triggered, with no power going to the load). This is significant for an application in which the embodiment controls a refrigerator because the off-state power has to be very low, and this arrangement is a particularly cost effective way to achieve it. Other applications (e.g. controlling lights or a thermostat) also benefit from similar low off-state power consumption

Recharge of the controller power supply 10 requires current flow through the rectifier B1, and this current will also flow to the gate node G of the triac T1. There is a possibility that this current could trigger the triac T1 prematurely, simply due to recharge of the power supply. To avoid this, one or more circuits can be included to reduce the charging current (for example by including a series resistance or a current limiting circuit) and/or reduce the sensitivity of the gate node to current (for example bypassing some current through bypass impedance ZG to MT1). A further purpose of the optional bypass impedance ZG is to improve the commutation performance of the triac.

The total charge transmitted from the gate driver circuit 12 to trigger the triac T1 cannot exceed the total charge transmitted from ZH and ZL to the controller power supply 10. For the circuit to work, the gate driver current (Itrig) is concentrated into short duration current pulses of amplitude sufficient to trigger the triac T1 reliably. By comparison, the current charging the power supply 10 is allowed to pass over a significantly longer period, at low amplitude.

Preferably the trigger current pulse is very short. However, as result of tolerance of components and operating conditions, a very short current pulse could be unreliable. Accordingly, the controller 11 may be arranged initially to generate a very short current pulse but detect when triggering has failed by sensing the rise of voltage to the power supply; if the controller 11 issues a trigger but the power supply input voltage (i.e. the output of the rectifier B1) is seen to subsequently rise then the controller may subsequently issue another triggering pulse (either at once or a short time later). This could for example be during the same half-cycle, but at a time when the mains voltage has risen further in the mains cycle so that the triggering could be more reliable even if the triggering pulse is the same. Optionally, the controller 10 may be operative to detect that the triggering pulses are not reliably triggering the triac T1, and start to generate a longer or larger current pulse to provide more effective triggering.

The embodiment of Fig. 3 can be varied in a number of ways within the scope of the invention. For example, the single rectifier B1 can be replaced in other embodiments with two separate rectifiers. One rectifier would have the function of transmitting the control signal from the controller 11 to the gate G of the triac T1. The other rectifier would have the function of generating power for the power supply unit 10. However, the use of a single rectifier B1 to perform both these functions is preferred.

In other embodiments, the power supply circuit may operate the triac T1 with the opposite polarity.

In the embodiment of Fig. 3, the gate trigger current is provided from either of the impedances ZL, ZH or both. However, in other embodiments the capacitive network would omit the impedance ZL, relying only on charge from ZH.

With a largely capacitive impedance for ZL and ZH, it is possible to minimise the energy absorbed by the power supply control system when the load is off. In this condition, the AC voltage appears across the triac MT1 - MT2 terminals and across the network ZL and ZH in series. Hence, if these are largely capacitive, energy absorbed by them can be small.

A further advantage of using a capacitive impedance for ZH is that high voltage impulses, typical of surge conditions, can be arranged to pass through ZH and be conducted to the gate terminal G of the triac T1 making it trigger. In some applications this is very beneficial because it protects the triac T1 from overvoltage conditions. It does, however, turn on the triac T1 which will conduct for some part of the mains cycle, hence powering the load briefly. There are some applications where this would not be acceptable but others where it would be, for example: motor-compressor control in refrigeration, heaters, and some lighting applications. Protective behaviour of this form allows the use of low-cost components while resisting high values of surge voltage. Alternative methods to protect against surges often require expensive additional protection devices.

In the first embodiment of Fig. 3, the power supply 10 ensures that the controller remains powered continuously while mains supply power is applied (whether or not power is supplied to the load). This is important since it is necessary to keep "state" information from one half-cycle of the supply to the next. The state information includes, typically:
- a time accumulator to track the passage of time during the on-time in which power is supplied to the load
- a logical state to indicate if the desired on-time has expired and power should no longer be supplied to the load (off-time).

At first application of power (from the un-powered state) both the accumulator and the expired state are reset. Only while the expired state remains in the reset state, power is supplied to the load. The accumulator is increased at a rate, at least during the on-time. When the accumulator reaches some threshold indicative of the desired total on-time, the expired state is set, therefore preventing further application of power to the load until the system is reset by removal and re-application of power.

A digital embodiment of the controller 11 could use a counter as the accumulator, incrementing with time or mains half-cycles, and a logical bit to hold the expired state. However, other embodiments are possible, for example forming the controller 11 using discrete components and/or using analogue rather than digital circuit techniques. The other embodiments would still provide the necessary functions and, in particular, for a timing application, maintain the accumulator and expired states. They are maintained even when power is not instantaneously available to the controller via the rectifier.

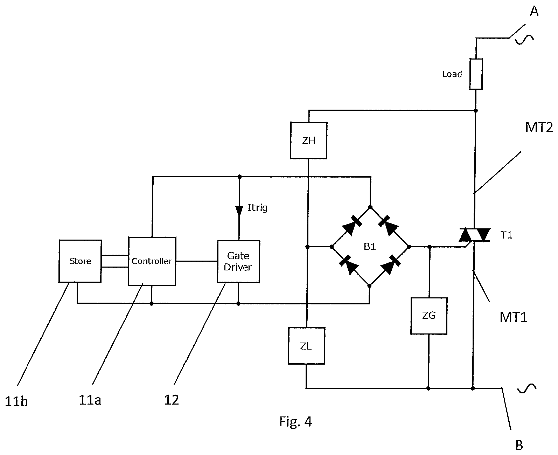

One such embodiment is the second embodiment of the invention shown in Fig. 4. Elements of the second embodiment having the same meaning as the first embodiment are given the same reference numerals. The second embodiment differs from the first embodiment of Fig. 3 only in the arrangement of the controller, and the omission of the power supply unit 10. The second embodiment includes a controller in two portions: a controller portion 11a with power applied only intermittently from the rectifier and a store 11b that may comprise one or more storage elements.

For a basic timing application, such as that shown in Fig. 2(a), the store 11b holds a time accumulator and an expired state in one or more elements. Other, more complex control implementations may have storage elements to hold (or represent) other states or conditions.

As an analogue implementation, a capacitor can be used as a time accumulator; charge being added (or removed) at least during the on-time. Its voltage then represents the elapsed time and when it reaches a threshold then the on-time can be determined to have expired. The expired state can be represented by the voltage/charge in a separate capacitor, with high charge representing the expired state. Conveniently, a single capacitor can be used to provide both the accumulation and expired states:
- During the on-time the capacitor charges at a rate
- While the capacitor voltage is below a threshold, the controller applies power to the load (on-time)
- After the capacitor voltage reaches the threshold, power is no longer applied to the load (off-state)
- In the off-state, the capacitor voltage is maintained (or further increased) to continue to prevent power being applied to the load
- When supply power is no longer applied, the capacitor voltage is reset.

Note that charge may be added or removed from the capacitor during the on-time, and the expiration can be determined by the voltage rising above or falling below a threshold.

An important function is to detect during the off-state when mains power is still applied and when it has been removed. In the off-state, the DC voltage output from the rectifier to the controller portion 11a is related to the applied mains voltage and the ratios of impedances in the network feeding the rectifier from the mains supply, but mainly the ratio of CH to CL. If the mains supply is completely removed, then no voltage will be provided by the rectifier. In this circumstance, capacitors used as store element(s) can be reset simply by draining their charge through some high value resistance. In many applications this gives acceptable performance. In some applications, however, there can be a residual voltage at the mains supply in the condition when the supply is nominally off. In these circumstances there would be a voltage output from the rectifier. If this couples in some way to storage elements then they may not reset fully; a subsequent switching cycle then may not give the desired on-time or other desired behaviour. In extreme, the expired state many not be reset so that no on-time would be generated on subsequent application of full mains power. To avoid undesired behaviour, it is necessary to detect that the applied mains voltage has reduced below some off-threshold. This can be determined from the voltage output from the rectifier; the critical circuit elements are reset when the rectifier output falls below a threshold, rather than when it falls substantially to zero. This can be achieved by a voltage-sensing circuit that preferably maintains capacitor charge when the rectifier output rises above a threshold. Alternatively, the rate of change of rectifier output voltage can be used instead of the direct voltage; a rate of change above a threshold being indicative of mains power still being applied and the capacitor charge(s) are maintained.

A scheme such as described can be implemented as a simple analogue circuit using low cost devices, either discrete or integrated. Note also that the gate driver function may also be integrated into the circuit of the controller portion 11a, rather than being provided as additional circuits.

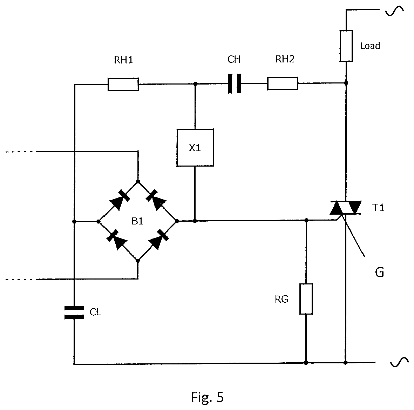

Other circuits may be added to enhance the behaviour and performance the circuit under surge conditions. For example, Fig. 5 shows a third embodiment the invention. The power supply 10, controller, and gate driver circuit 12 are as in the first embodiment of Fig. 3 or as in the second embodiment of Fig. 4, and are omitted for simplicity. The second embodiment also includes the circuits ZH, ZL and ZG, and Fig. 5 shows a specific form these might take in either embodiment: in Fig. 5, ZH comprises a capacitor CH, and resistors RH1 and RH2; ZL comprises a capacitor CL; and ZG comprises a resistor RG. Forming ZH with one or more capacitive elements in series with one or more resistive ones avoids excessive current passing through ZH and ZL under transient conditions.

The third embodiment differs from the first or second in that an additional surge current circuit X1 is provided, which is arranged to pass current whenever a surge pulse is applied via the AC power connections. For example, X1 could be a capacitor, a bidirectional transient voltage suppressor (TVS) device or a more complicated circuit. The required characteristic of X1 is to pass gate trigger current when high levels of current flow through CH - characteristic of surge conditions applied via the mains connections. Using a capacitor as X1, fast application of high current through CH preferentially passes through X1 to the gate G of the triac T1. Alternatively, using a voltage-limiting device such as a TVS as X1, high current through CH develops sufficient voltage across RH1 to cause conduction of X1, passing the current to the gate of the triac. A further method of triggering the triac under surge conditions is to limit the voltage across the rectified output of the rectifier B1 using a device such as a zener diode or other means. However it can be difficult to achieve good protection under surge conditions and good triggering of the triac under normal conditions due to conflicting requirements on the characteristics of ZL.

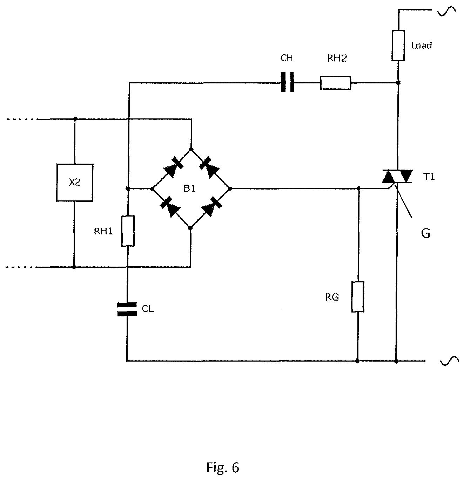

A fourth embodiment, which facilitates improve setting of behaviour under surge conditions is illustrated in Fig. 6. Again, this is a variant of the first or second embodiment, and elements of those embodiments which are the same in the fourth embodiment are omitted in Fig. 6. Note that in the fourth embodiment, as compared to the third embodiment, RH1 is repositioned in relation to the rectifier and that over-voltage protection device X2 is added, X1 having been removed.

When the triac is off, a fast over-voltage event (such as a surge) applied via the mains supply will couple via the load and the circuit RH2, CH, RH1 and CL. Supposing that the over-voltage rise time is short in comparison to the circuit time constants, the output voltage from the rectifier (applied to X2) rises as a proportion of applied voltage, related to the ratio of resistances RH1 to RH2 (the load impedance generally being low in comparison). If X2 is a device that conducts current appreciably only when a threshold voltage is exceeded (e.g. a zener diode) then the rectifier will conduct current once the applied overvoltage exceeds a threshold that can be determined mainly by the X2 threshold and the ratio RH1 to RH2. When X2 conducts, the corresponding current flows to the triac gate which is then arranged to trigger. Triggering the triac prevents it being subjected to excessive overvoltage.

Under normal operating conditions (without applied overvoltage), X2 need not interfere with circuit function or can be used for some other function if desired. Alternatively, the overvoltage characteristic can be provided by a behaviour of the controller circuit itself, rather than being provided by an additional device (X2). The value of RH1 must be taken into account in relation to passage of trigger current to the gate of the triac but it is practical to choose a suitable value that also allows acceptable overvoltage protection behaviour. Forming ZL with one or more series resistive elements allows surge-protection behaviour (similarly to how X1 provides it in the third embodiment).

Such an implementation may reduce the cost of the overall circuit, since it avoids using a bidirectional overvoltage device (X1), which is typically more expensive than a zener diode. Further, if the overvoltage characteristic is provided by a controller behaviour, or the device X2 is used also within a controller function, then there is an overall cost saving.

In contrast to the known system of Fig. 1, the controller 11 or 11a of the embodiments of Figs. 3 to 6 are powered via rectifier B1 from the gate circuit of the triac, and the zero-voltage reference of the controller is not connected to the MT1 terminal of the triac T1, as is conventional in controller/triac combinations. If the controller 11 or 11a requires no additional connections in the application system then this is not a hindrance. An example of such a supply circuit system is a timing system in which the controller 11 or 11a turns the triac T1 on and off at predetermined periods after the first application of power. However, other applications may require the controller 11 or 11a to be connected to other circuits; for example, in the case that the power supply is used as a thermostat controlled by a remote sensor. Advantageously, these other circuits would have no current path to the AC supply connections.

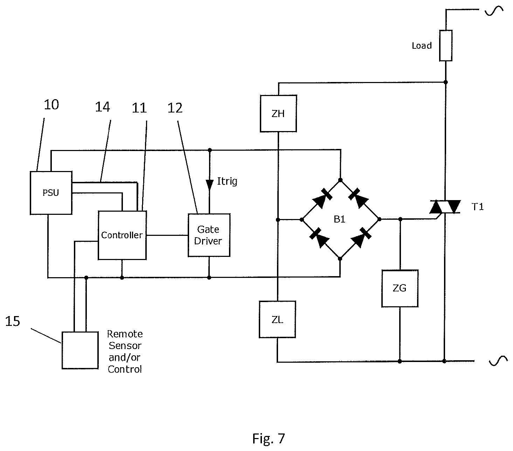

Such an embodiment is shown in Fig. 7, which differs from the embodiment of Fig. 3 only in that an sensor 15 is provided (e.g. remote from the controller 11) to control the controller 11. Here, there are no the current paths from the remote sensor 15, so there is no disruption of the gate triggering or controller powering functions. In other embodiments the remote sensor 15 may be replaced by another form of control circuit. Although Fig. 5 shows the signal line 14 of Fig. 3 being present, such that the control of the controller 11 may be based on both the timing of the AC circuit and the output of the sensor 15, the signal line 14 may optionally be omitted.

Particular applications of embodiments of the invention include:
- As a starting device for a motor-compressor in a refrigerator. In this case the load is the start winding in the split-phase induction motor. The control function is principally to activate the start winding for a short period from first application of AC power. Since this is based on timing, no additional connections are needed to the controller.
- For thermostat control for refrigeration or heating. Here, the system would include a temperature sensor and optionally a temperature-adjustment control. Either or both of these can be integrated within the physical control device or provided remotely, connected by a cable. Neither have conduction elsewhere; triggering and powering within the device are not affected
- As a light-sensitive control, for example for lighting. A light sensor, either integrated within the physical device or remote and connected by a cable, provides a signal to the controller that then operates the triac to power some load, such as artificial lights.

In all of the above applications, the controller preferably receives a signal derived from the voltage or current from the rectifier to synchronise operation to the mains cycle and/or to count mains cycles.

## Claims

1. A power supply circuit for controlling the supply of power from an alternating current, AC, power source to a load, the power supply circuit comprising:
a triac unit (T1) for arrangement in series with the load, the triac unit (T1) having a control input (G), an MT1 terminal and an MT2 terminal;
a controller (11; 11a, 11b) operative to generate a control signal, the controller (11; 11a) being operative to trigger the triac unit (T1) using the control signal;
a rectifier unit comprising at least one rectifier (B1); and
a capacitive network (ZL,ZH), a terminal of the capacitive network being electrically connected to an input (11) of the rectifier unit;
wherein the rectifier unit is operatively connected between the controller (11; 11a, 11b) and the control input (G) of the triac unit (T1), and operative:
(i) to conduct the control signal from the controller (11; 11a, 11b) to the control input (G) of the triac unit (T1), to trigger the triac unit (T1) using the control signal, and
(ii) to transmit electrical power to the controller (11; 11a, 11b);
the power supply circuit being **characterized in that**:
the capacitive network (ZL, ZH) includes a capacitive circuit (ZH) having a first and a second terminals, wherein the first terminal is connected to the input (11) of the rectifier unit, and the second terminal is connected to the MT2 terminal of the triac unit (T1).

2. A power supply circuit according to claim 1 further comprising a power supply unit (10), the control signal being conducted to the control input (G) of the triac unit (T1) in the form of a current pulse of a duration less than a charging period of the power supply unit (10).

3. A power supply circuit according to claim 1 in which the controller (11a, 11b) includes a capacitor for storing a charge, the controller being operative to generate the control signal in dependence on the stored charge.

4. A power supply circuit according to any preceding claim, further including a current bypass circuit (ZG) connected between the control input (G) of the triac unit (T1) and the MT1 terminal of the triac unit (T1).

5. A power supply circuit according to any preceding claim, further including a surge current circuit (X1; X2) operative, in the case that a surge is superimposed on the power from the alternating current, AC, power source, to transmit a triggering signal to the control input (G) to trigger the triac unit (T1), the surge current circuit (X2) preferably being connected between outputs (O1, O2) of the rectifier (B1).

6. A power supply circuit according to any preceding claim, further comprising a sensor (15) operative to sense a characteristic of the environment of the sensor, generating an input signal using the sensed characteristic, and to transmit the input signal to the controller, the controller being operative to generate the control signal in dependence on the input signal.

7. A power supply circuit according to any preceding claim,
the controller (11; 11a, 11b) being operative to detect whether the control signal has triggered the triac unit (T1), and, if the determination is negative, to transmit another control signal to trigger the triac unit (T1).

8. A power supply circuit according to any preceding claim comprising a circuit operative to detect an increasing current or voltage in the control signal conducted to the control input (G) of the triac unit (T1) by the rectifier unit, and accordingly to control the timing with which the controller (11; 11a, 11b) generates the control signal.

## Patentansprüche

1. Stromversorgungsschaltung zum Steuern der Zufuhr von Strom von einer Stromquelle für Wechselstrom, AC, zu einer Last, wobei die Stromversorgungsschaltung Folgendes umfasst:
eine Triac-Einheit (T1) zur Anordnung in Reihe mit der Last, wobei die Triac-Einheit (T1) einen Steuerungseingang (G), einen MT1-Anschluss und einen MT2-Anschluss aufweist;
eine Steuerungseinrichtung (11; 11a, 11b), die betriebsfähig ist, um ein Steuerungssignal zu erzeugen, wobei die Steuerungseinrichtung (11; 11a) betriebsfähig ist, um die Triac-Einheit (T1) unter Verwendung des Steuerungssignals zu zünden;
eine Gleichrichtereinheit, die mindestens einen Gleichrichter (B1) umfasst; und
ein kapazitives Netzwerk (ZL, ZH), wobei ein Anschluss des kapazitiven Netzwerks mit einem Eingang (I1) der Gleichrichtereinheit elektrisch verbunden ist,
wobei die Gleichrichtereinheit betriebsfähig zwischen die Steuerungseinrichtung (11; 11a, 11b) und den Steuerungseingang (G) der Triac-Einheit (T1) geschaltet ist, und betriebsfähig ist, um:
(i) das Steuerungssignal von der Steuerungseinrichtung (11; 11a, 11b) zum Steuerungseingang (G) der Triac-Einheit (T1) zu leiten, um die Triac-Einheit (T1) unter Verwendung des Steuerungssignals zu zünden, und
(ii) elektrischen Strom zur Steuerungseinrichtung (11; 11a, 11b) zu übertragen,
wobei die Stromversorgungsschaltung **dadurch gekennzeichnet ist, dass**:
das kapazitive Netzwerk (ZL, ZH) eine kapazitive Schaltung (ZH) mit einem ersten und einem zweiten Anschluss einschließt, wobei der erste Anschluss mit dem Eingang (11) der Gleichrichtereinheit verbunden ist, und der zweite Anschluss mit dem MT2-Anschluss der Triac-Einheit (T1) verbunden ist.

2. Stromversorgungsschaltung nach Anspruch 1, ferner eine Stromversorgungseinheit (10) umfassend, wobei das Steuerungssignal in Form eines Stromimpulses mit einer Dauer, die kürzer als eine Ladeperiode der Stromversorgungseinheit (10) ist, zum Steuerungseingang (G) der Triac-Einheit (T1) geleitet wird.

3. Stromversorgungsschaltung nach Anspruch 1, bei der die Steuerungseinrichtung (11a, 11b) einen Kondensator zum Speichern einer Ladung einschließt, wobei die Steuerungseinrichtung betriebsfähig ist, um das Steuerungssignal in Abhängigkeit von der gespeicherten Ladung zu erzeugen.

4. Stromversorgung nach einem der vorhergehenden Ansprüche, ferner eine Stromüberbrückungsschaltung (ZG) einschließend, die zwischen den Steuerungseingang (G) der Triac-Einheit (T1) und den MT1-Anschluss der Triac-Einheit (T1) geschaltet ist.

5. Stromversorgungsschaltung nach einem der vorhergehenden Ansprüche, ferner eine Spitzenstromschaltung (X1; X2) einschließend, die betriebsfähig ist, um, falls dem Strom von der Stromquelle für Wechselstrom, AC, eine Stromspitze überlagert ist, ein Zündsignal zum Steuerungseingang (G) zu übertragen, um die Triac-Einheit (T1) zu zünden, wobei die Spitzenstromschaltung (X2) vorzugsweise zwischen Ausgänge (O1, O2) des Gleichrichters (B1) geschaltet ist.

6. Stromversorgungsschaltung nach einem der vorhergehenden Ansprüche, ferner einen Sensor (15) umfassend, der betriebsfähig ist, um ein Merkmal der Umgebung des Sensors zu erfassen, wobei er unter Verwendung des erfassten Merkmals ein Eingangssignal erzeugt, und um das Eingangssignal zur Steuerungseinrichtung zu übertragen, wobei die Steuerungseinrichtung betriebsfähig ist, um das Steuerungssignal in Abhängigkeit von dem Eingangssignal zu erzeugen.

7. Stromversorgungsschaltung nach einem der vorhergehenden Ansprüche,
wobei die Steuerungseinrichtung (11; 11a, 11b) betriebsfähig ist, um zu ermitteln, ob das Steuerungssignal die Triac-Einheit (T1) gezündet hat, und falls die Bestimmung negativ ist, um ein weiteres Steuerungssignal zu übertragen, um die Triac-Einheit (T1) zu zünden.

8. Stromversorgung nach einem der vorhergehenden Ansprüche, eine Schaltung umfassend, die betriebsfähig ist, um einen ansteigenden Strom oder eine ansteigende Spannung in dem Steuerungssignal zu ermitteln, das durch die Gleichrichtereinheit zum Steuerungseingang (G) der Triac-Einheit (T1) geleitet wird, und dementsprechend die Zeitgebung zu steuern, mit der die Steuerungseinrichtung (11; 11a, 11b) das Steuerungssignal erzeugt.

## Revendications

1. Circuit d'alimentation en énergie électrique pour commander l'alimentation en énergie électrique en provenance d'une source d'énergie électrique courant alternatif, AC, à une charge, le circuit d'alimentation en énergie électrique comprenant :
une unité de triac (T1) destinée à être agencée en série avec la charge, l'unité de triac (T1) comportant une entrée de commande (G), une borne MT1 et une borne MT2 ;
un dispositif de commande (11 ; 11a, 11b) fonctionnel pour générer un signal de commande, le dispositif de commande (11 ; 11a) étant fonctionnel pour déclencher l'unité de triac (T1) en utilisant le signal de commande ;
une unité de redresseur(s) comprenant au moins un redresseur (B1) ; et
un réseau capacitif (ZL, ZH), une borne du réseau capacitif étant connectée électriquement à une entrée (I1) de l'unité de redresseur(s) ;
dans lequel l'unité de redresseur(s) est connectée de manière fonctionnelle entre le dispositif de commande (11 ; 11a, 11b) et l'entrée de commande (G) de l'unité de triac (T1), et est fonctionnelle :
(i) pour conduire le signal de commande en provenance du dispositif de commande (11 ; 11a, 11b) à l'entrée de commande (G) de l'unité de triac (T1), pour déclencher l'unité de triac (T1) en utilisant le signal de commande, et
(ii) pour transmettre de l'énergie électrique au dispositif de commande (11 ; 11a, 11b) ;
le circuit d'alimentation en énergie électrique étant **caractérisé en ce que** :
le réseau capacitif (ZL, ZH) inclut un circuit capacitif (ZH) comportant des première et seconde bornes, dans lequel la première borne est connectée à l'entrée (I1) de l'unité de redresseur(s), et la seconde borne est connectée à la borne MT2 de l'unité de triac (T1).

2. Circuit d'alimentation en énergie électrique selon la revendication 1, comprenant en outre une unité d'alimentation en énergie électrique (10), le signal de commande étant conduit à l'entrée de commande (G) de l'unité de triac (T1) sous la forme d'une impulsion de courant d'une durée inférieure à une période de charge de l'unité d'alimentation en énergie électrique (10).

3. Circuit d'alimentation en énergie électrique selon la revendication 1, dans lequel le dispositif de commande (11a, 11b) inclut un condensateur pour stocker une charge, le dispositif de commande étant fonctionnel pour générer le signal de commande en fonction de la charge stockée.

4. Circuit d'alimentation en énergie électrique selon l'une quelconque des revendications précédentes, incluant en outre un circuit de dérivation de courant (ZG) connecté entre l'entrée de commande (G) de l'unité de triac (T1) et la borne MT1 de l'unité de triac (T1).

5. Circuit d'alimentation en énergie électrique selon l'une quelconque des revendications précédentes, incluant en outre un circuit de courant de surtension (X1 ; X2) fonctionnel, dans le cas où une surtension est superposée sur l'énergie électrique en provenance de la source d'énergie électrique courant alternatif, AC, pour transmettre un signal de déclenchement à l'entrée de commande (G) pour déclencher l'unité de triac (T1), le circuit de courant de surtension (X2) étant de préférence connecté entre des sorties (01, O2) du redresseur (B1).

6. Circuit d'alimentation en énergie électrique selon l'une quelconque des revendications précédentes, comprenant en outre un capteur (15) fonctionnel pour détecter une caractéristique de l'environnement du capteur, qui génère un signal d'entrée en utilisant la caractéristique détectée, et pour transmettre le signal d'entrée au dispositif de commande, le dispositif de commande étant fonctionnel pour générer le signal de commande en fonction du signal d'entrée.

7. Circuit d'alimentation en énergie électrique selon l'une quelconque des revendications précédentes,
le dispositif de commande (11 ; 11a, 11b) étant fonctionnel pour détecter si le signal de commande a déclenché ou non l'unité de triac (T1), et, si la détermination est négative, pour transmettre un autre signal de commande pour déclencher l'unité de triac (T1).

8. Circuit d'alimentation en énergie électrique selon l'une quelconque des revendications précédentes, comprenant un circuit fonctionnel pour détecter une augmentation de courant ou de tension dans le signal de commande conduit à l'entrée de commande (G) de l'unité de triac (T1) par l'unité de redresseur(s), et par conséquent, pour commander la temporisation selon laquelle le dispositif de commande (11 ; 11a, 11b) génère le signal de commande.
